# EUROPEAN PATENT SPECIFICATION

(11) **EP 0 801 397 B1**
(45) Date of publication and mention of the grant of the patent: **03.09.2003**
(21) Application number: 97302367.4
(22) Date of filing: 07.04.1997
(51) Int. Cl.: G11C 11/412

(54) **Improvements in or relating to semiconductor memory devices**
Verbesserungen für oder in Bezug auf Halbleiterspeicheranordnungen
Perfectionnements dans ou relatifs à des dispositifs de mémoire à semi-conducteur

(30) Priority: 08.04.1996 US 15014
(43) Date of publication of application: 15.10.1997
(73) Proprietor: TEXAS INSTRUMENTS INC., Dallas, Texas 75243 (US)
(72) Inventor: Madan, Sudhir K., Richardson, Texas 75080 (US)
(74) Representative: Harris, Ian Richard

(56) References cited:
- US-A- 5 422 857
- EILHARD HASELHOFF: "Ein MOS-Speicher und seine Schaltungstechnik" ELEKTRONIK., vol. 21, MUNCHEN DE, pages 263-264, XP002064954

## Description

### TECHNICAL FIELD OF THE INVENTION

The present invention relates in general to semiconductor memory devices and more particularly to a low voltage, low power static random access memory cell.

### BACKGROUND OF THE INVENTION

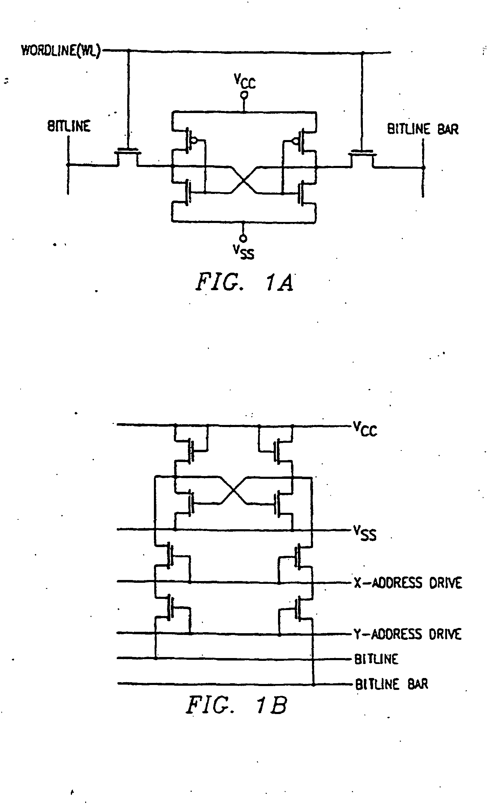

Schematics of two typical static random access memory (SRAM) are shown in FIGURES 1A and 1B. The cell in FIGURE 1A is called a six transistor (6T) SRAM cell and comprises a pair of cross-coupled inverters to store a data bit state and pair of pass transistors to read and write a data bit between the cross-coupled inverters and a pair of bitlines. The bus which connects the pass transistor gates is called a wordline. To access a particular cell in an array, for reading or writing, the wordline connected to its pass transistor gates is activated to turn on the pass transistors.

The cell in FIGURE 1B is an eight transistor (8T) SRAM cell and comprises a pair of cross-coupled inverters to store a data bit state and a pair of two transistors in series between the output nodes of the cross-coupled inverters and a pair of bitlines. The two transistors in series between the output of an inverter and a bitline are also called an X-pass transistor and a Y-pass transistor. The X-pass transistors have their gates connected to a row select bus running in the X-direction called an X-address drive and the Y-pass transistors have their gates connected to a column select bus called a Y-address drive running in the Y-direction. To access a cell in an array, for reading or writing, both X-address and Y-address drives must be turned ON.

DC characteristics of a static random access memory (SRAM) cell are determined by three parameters - read current, bitline write voltage (i.e. trip voltage), and static noise margin. The static noise margin reflects upon the cell stability against noise in the circuit during a read operation. A relatively high noise margin is a desired feature of a static random access memory cell. However, for low voltage/power devices with a supply voltage of typically 1 volt or below, obtaining a good static noise margin is difficult because the threshold voltages of the transistors within a cell are kept low to maintain a certain level of drive current for the transistors.

The static noise margin can be increased by increasing the beta ratio of a cell. The beta ratio for a 6T cell is defined as the ratio of the drive currents for the driver (pull-down) transistor to that for the pass transistor when they have the same threshold voltage. For the 8T cell, the beta ratio is defined as the ratio of the drive current for the driver transistor to that for the series of combination of the X-pass and Y-pass transistors. For the 6T cell, the beta ratio is also the same as the width ratio of the driver and the pass transistors if they have the same gate length and threshold voltage.

A disadvantage of a high beta ratio is that it is difficult to write into a cell because an increase in the beta ratio lowers the bitline write voltage for the cell. This problem becomes more severe as the supply voltage Vcc is reduced for low voltage and or low power applications. Typically, a voltage below 1.5V is considered a low voltage implementation. Therefore, it is desirable to increase the beta ratio of the memory cell without adversely affecting its write capability.

Examples of static random access memory cells are shown in the following documents. US Patent No 5,422,857 discloses a memory cell comprising a pair of cross-coupled inventors, each invertor having connected between an output node thereof and a pass node a pass transistor and a write pass transistor and discloses the preamble of independent claims 1, 2 and 3. A paper entitled "Ein MOS-Speicher und seine Schaltungstechnik" by Eilhard Haselhoff published in Elektronik, vol 21, Muenchen, DE at pages 263-264, XP002064954 describes a number of techniques for reducing power consumption of memory cells, including one of using an additional pair of transistors to reduce the power consumption of a non-selected cell in a similar manner to that described above with reference to Figure 1B (the 8T circuit).

### SUMMARY OF THE INVENTION

From the foregoing, it may be appreciated that a need has arisen for a memory cell with an increased static noise margin without adversely affecting its write capacity. In accordance with the present invention, a low voltage, low power SRAM cell is provided that substantially eliminates or reduces disadvantages and problems associated with conventional SRAM cell designs.

Viewed from a first aspect, the present invention provides a memory cell comprising: first and second cross-coupled inverters, the first inverter including a first output node of the first inverter and the second inverter including a second output node; a first pass transistor connected between the output node of the first inverter and a first pass node; a first write pass transistor connected between the output node of the inverter and the first pass node; a second pass transistor connected between the output node of the second inverter and a second pass node; and a second write pass transistor connected between the output node of the second inverter and the second pass node;
characterised by the cell further comprising: a first bitline select transistor connected between the first pass node and a first bitline; a second bitline select transistor connected between the second pass node and a second bitline; wherein the first and second write pass transistors are write only pass transistors.

Viewed from another aspect, the present invention provides a memory cell comprising: first and second cross-coupled inverters, the first inverter including a first output node of the first inverter and the second inverter including a second output node; a first pass transistor connected between the output node of the first inverter and a first bitline; a first write pass transistor connected between the output node of the inverter and a first pass node; a second pass transistor connected between the output node of the second inverter and a second bitline; and a second write pass transistor connected between the output node of the second inverter and a second pass node;
characterised by the cell further comprising: a first bitline select transistor connected between the first bitline and the first pass node; a second bitline select transistor connected between the second bitline and a second pass node; wherein the first and second write pass transistors are write only pass transistors.

Viewed from a further aspect, the present invention provides a memory cell comprising: first and second cross-coupled inverters, the first inverter including a first output node of the first inverter and the second inverter including a second output node; a first pass transistor connected between a first pass node and a first bitline; a first write pass transistor connected between the first bitline and the first pass node; a second pass transistor connected between a second pass node and a second bitline; and a second write pass transistor connected between the second bitline and the second pass node; characterised by the cell further comprising: a first bitline select transistor connected between the output node of the first transistor and the first pass node; a second bitline select transistor connected between the output node of the second inverter and the second pass node; wherein the first and second write pass transistors are write only pass transistors.

Embodiments of the invention provide technical advantages over conventional static random access memory cell devices. For example, one technical advantage is the use of an extra write pass transistor to alter the DC characteristics of the SRAM. By selecting a narrower width for the pass transistor and keeping the write pass transistor OFF during read, a high beta ratio is achieved to provide an increase in the static noise margin for the cell. By designing a wider write pass transistor width and turning ON both the pass and write pass transistors during write, the beta ratio of the cell is significantly reduced during the write operation, hence making it easier to write into the cell. If the write pass transistor width is significantly larger than that for the pass transistor, the pass transistor need not be turned ON during the write operation. Thus, the pass transistor can be used for the read operation and the write pass transistor can be used for the write operation.

Unlike a 6T SRAM array where turning ON a wordline activates all the cells on that wordline, in the 10T cell only the addressed cell is activated, thereby reducing the power loss associated with accessing a cell. Activating a cell causes current to flow from the bitline to the Vss through the cell. Reducing the number of activated cells will reduce the power for the memory. Typically, in a 10T cell inside an array, the gates for the bitline select transistors are connected to the Y-address drive and the gates for the pass transistors and the write pass transistors obtain their signal from the X-address signal. The current in a cell only flows when 1) the bitline select transistors are turned ON and 2) pass transistors and or write pass transistors are turned ON. Since this can happen for the addressed cell only at any time, the power loss is reduced. In the above discussion for a 10T cell array, we assume that the data consists of a single bit only. However, for the case where the data consists of say n bits per address, then typically, n cells will be activated for any address during a read or write operation. Other examples are readily apparent to one skilled in the art from the following figures, description, and claims.

### BRIEF DESCRIPTION OF THE DRAWINGS

For a more complete understanding of the present invention and the advantages thereof, reference is now made to the following description of exemplary embodiments thereof taken in conjunction with the accompanying drawings, wherein like reference numerals represent like parts, in which:
FIGURE 1A illustrates a simplified schematic diagram of a six transistor static random access memory cell;
FIGURE 1B illustrates a simplified schematic diagram of an eight transistor static random access memory cell;
FIGURE 2 illustrates a simplified schematic diagram of a low voltage, low power static random access memory cell in accordance with an embodiment of the present invention; and
FIGURE 3 illustrates a simplified schematic diagram of an alternate embodiment of the low voltage, low power static random access memory cell of the present invention.

### DETAILED DESCRIPTION OF THE INVENTION .

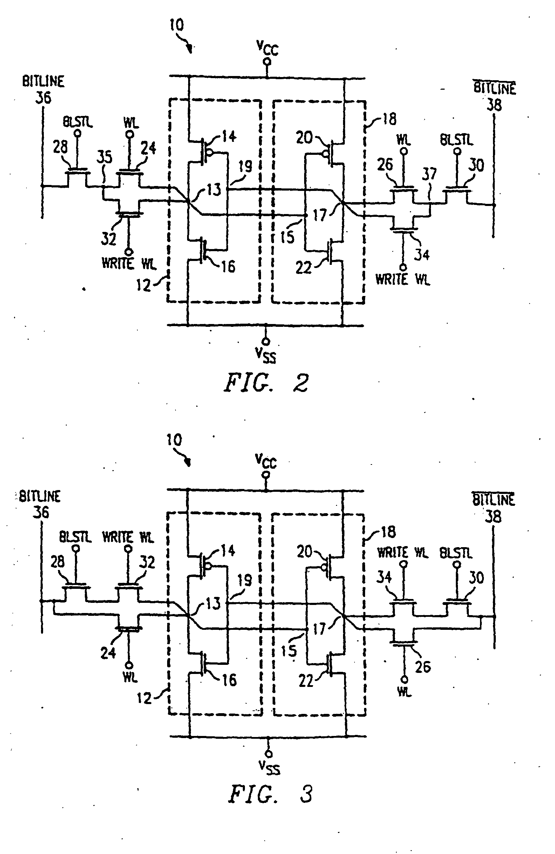

FIGURE 2 is a simplified schematic diagram of a ten transistor low voltage, low power SRAM memory cell 10. Low voltage, low power SRAM cell 10 includes a first inverter 12 having a first pull-up transistor 14 between a high end of the supply voltage node, Vcc, and a first inverter output node 13. First inverter 12 also has a first pull-down transistor 16 connected between output node 13 and a low end of the supply voltage node, Vss. The SRAM cell 10 also includes a second inverter 18 having a second pull-up transistor 20 and a second pull-down transistor 22. Second pull-up transistor 20 is connected between the Vcc and an output node 17 of second inverter 18. Second pull-down transistor is connected between output node 17 and the Vss. The two inverters are cross-coupled, i.e., output node 13 of first inverter 12 is connected to an input node 15 of second inverter 18 and output node 17 of the second inverter 18 is connected to an input node 19 of first inverter 12.

A first pass transistor 24 is connected between output node 13 of first inverter 12 and a first pass node 35. A first bitline select transistor 28 is placed between first pass node 35 and a first bitline (Bitline) 36. A first write pass transistor 32 is also connected between first pass node 35 and output node 13 of first inverter 12. The cell also includes a second pass transistor 26 connected between output node 17 of second inverter 18 and a second pass node 37. A second bitline select transistor 30 is placed between second pass node 37 and a second bitline (also called Bitline Bar) 38. A second write pass transistor 34 is also connected between second pass node 37 and output node 17 of second inverter 18.

In an SRAM array, the gates of pass transistors 24 and 26 are connected to a bus called Wordline (WL), the gates for write pass transistors 32 and 34 are connected to a bus called Write Wordline (Write WL), and the gates for bitline select transistors 28 and 30 are connected to a bus called Bitline Select Transistor Line (BLSTL). Typically, the signal for the Wordline and the Write Wordline are derived from the X-address, or row select, and the signal for the Bitline Select Transistor Line is derived from the Y-address, or column select. The Bitline Select Transistor Line runs perpendicular to the Wordline and the Write Wordline buses. That is, if the Wordline and Write Wordline buses are running in the X-direction, the Bitline Select Transistor Line will run in the Y-direction. The Bitline and Bitline Bar buses will also run in the Y-direction.

In the preferred embodiment, the pull-down transistors have n-channel configurations and have twice the width of the pass transistors which are also of n-channel configuration. The pull-up transistors have p-channel configurations and have widths around 1 to 1.5 times the width for the pass transistors. The width of the bitline select transistors which have n-channel configurations are about 4 times that of the pass transistors and the width of the write pass transistors which have n-channel configurations are 1.5 times that of the pass transistors. The transistors may also have different threshold voltages. A lower threshold voltage for the bitline select transistors compared to that for the pass transistors is expected to increase the read current of a cell and make it easier to write into the cell.

In the above embodiment shown in the FIGURE 2, the order of the bitline select transistor and the parallel combination of the pass and write transistors placed between a bitline and an output node of an inverter can be reversed. The SRAM cell can have the first bitline select transistor 28 connected between the output node 13 of the first inverter 12 and the first pass node 35. The parallel combination of the first pass transistor 24 and the first write pass transistor 32 is connected between the first pass node 35 and the first bitline 36. The second bitline select transistor 30 is connected between the output node 17 of the second inverter 18 and the second pass node 37. The parallel combination of the second pass transistor 26 and the second write pass transistor 34 is connected between the second pass node 37 and the second bitline 38.

FIGURE 3 is a simplified schematic diagram showing another embodiment of a low voltage, low power SRAM cell 10. The cell includes a pair of cross-coupled inverters 12 and 18. In this embodiment, a first pass transistor 24 is connected directly between output node 13 of first inverter 12 and first bitline 36 and a second pass transistor 26 is connected directly between output node 17 of second inverter 18 and second bitline 38. A series combination of first write pass transistor 32 and first bitline select transistor 28 is also connected between output node 13 of first inverter 12 and first bitline 36. Also, a series combination of second write pass transistor 34 and second bitline select transistor 30 is placed between output node 17 of second inverter 18 and second bitline 38. In this embodiment, the read operation is performed by turning ON the pass transistors and the write operation is performed by turning ON the write pass transistors and bitline select transistors. Optionally, during the write operation the pass transistors could also be turned ON to make it easier to write.

Note that in a second embodiment, the order of the bitline select transistors and the write pass transistors can be reversed. SRAM cell 10 can have first write pass transistor 32 connected to first bitline 36 and first pass node 35, and first bitline select transistor 28 connected to first pass node 35 and output node 13 of first inverter 12. Similarly, second write pass transistor 34 can be connected to second bitline 38 and second pass node 37, with second bitline select transistor 30 connected to second pass node 37 and second output node 17 of the second inverter 18.

In the above embodiments, the pull-up and the pull-down transistors in the inverters have p-channel and n-channel configurations, respectively. However, a pull-up transistor could be replaced by a resistor as done in a four transistor, two resistor cell. The pull-up transistor can be built in a substrate along with the other transistors or it could be formed in a thin film polycrystalline silicon material (TFT). The substrate could be single crystalline bulk silicon, silicon on insulator, etc.

Thus, it is apparent that there has been provided, in accordance with the present invention, a low voltage, low power static random access memory cell that satisfies the advantages set forth above. Although embodiments of the invention have been described in detail, it should be understood that various changes, substitutions, and alterations can be made within the scope of the invention. For example, although direct connections are shown between transistors, these transistors may be coupled to each other by one or more intermediate components such as resistors, capacitors, and/or inductors while still providing a substantially similar operating capability. Other examples are readily ascertainable by one skilled in the art and can be made without departing from the scope of the present invention.

## Claims

1. A memory cell comprising:
first and second cross-coupled inverters (12, 18), the first inverter including a first output node (13) of the first inverter and the second inverter including a second output node (17);
a first pass transistor (24) connected between the output node of the first inverter and a first pass node (35);
a first write pass transistor (32) connected between the output node of the inverter and the first pass node;
a second pass transistor (26) connected between the output node of the second inverter and a second pass node (37); and
a second write pass transistor (34) connected between the output node of the second inverter and the second pass node;
**characterised by** the cell further comprising:
a first bitline select transistor (28) connected between the first pass node and a first bitline (36);
a second bitline select transistor (30) connected between the second pass node and a second bitline (38);
wherein the first and second write pass transistors are write only pass transistors.

2. A memory cell comprising:
first and second cross-coupled inverters (12, 18), the first inverter including a first output node (13) of the first inverter and the second inverter including a second output node (17);
a first pass transistor (24) connected between the output node of the first inverter and a first bitline (36);
a first write pass transistor (32) connected between the output node of the inverter and a first pass node;
a second pass transistor (26) connected between the output node of the second inverter and a second bitline (38); and
a second write pass transistor (34) connected between the output node of the second inverter and a second pass node;
**characterised by** the cell further comprising:
a first bitline select transistor (28) connected between the first bitline and the first pass node;
a second bitline select transistor (30) connected between the second bitline and a second pass node;
wherein the first and second write pass transistors are write only pass transistors.

3. A memory cell comprising:
first and second cross-coupled inverters (12, 18), the first inverter including a first output node (13) of the first inverter and the second inverter including a second output node (17);
a first pass transistor (24) connected between a first pass node (35) and a first bitline (36);
a first write pass transistor (32) connected between the first bitline and the first pass node;
a second pass transistor (26) connected between a second pass node (37) and a second bitline (38); and
a second write pass transistor (34) connected between the second bitline and the second pass node;
**characterised by** the cell further comprising:
a first bitline select transistor (28) connected between the output node of the first inverter and the first pass node;
a second bitline select transistor (30) connected between the output node of the second inverter and the second pass node;
wherein the first and second write pass transistors are write only pass transistors.

4. The memory cell of Claim 1 or Claim 2 or Claim 3, wherein said first inverter includes a first pull-up transistor (14) and a first pull-down transistor (16) and the said second inverter includes a second pull-up transistor (20) and a second poll down transistor (22).

5. The memory cell of any preceding claim, wherein said first inverter includes a p-channel first pull-up transistor (14) and an n-channel first pull-down transistor (16) and the said second inverter includes a p-channel second pull-up transistor (20) and an n-channel second pull-down transistor (22).

6. The memory cell of any preceding claim, wherein said first and second pass transistors, first and second bitline select transistors, and first and second write only pass transistors are N-channels.

7. The memory cell of any preceding claim, wherein the first write only pass transistor and the first bitline select transistor have larger widths than the first pass transistor and the second write only pass transistor and the second bitline select transistor have larger widths than the second pass transistor.

8. The memory cell of any preceding claim, wherein the first write only pass transistor has 0.5 times or larger width than the first pass transistor and the second write only pass transistor has 0.5 times or larger width than the second pass transistor.

9. The memory cell of any preceding claim, wherein the cell is used for low voltage or low power applications having a supply voltage of 1.5 volts or less.

10. The memory cell of any preceding claim, wherein the first and second pass transistors have p-channel configurations.

11. The memory cell of any preceding claim, wherein the first and second write only pass transistors have p-channel configurations.

12. The memory cell of any preceding claim, wherein the first and second bitline select transistors have p-channel configurations.

13. The memory cell of any preceding claim, wherein the memory cell is a static random access memory cell.

14. A method of operating a memory cell having a structure of claim 1 or claim 3, comprising the steps of:
asserting a wordline signal to the first and second pass transistors associated with a plurality of cells in the memory for a read operation;
asserting a bitline select signal to the first and second bitline select transistors associated with a first one of the plurality of cells for the read operation such that the first one of the plurality of cells is activated without activating any other of the plurality of the cells;
deasserting a write wordline signal to the first and second write only pass transistors associated with the plurality of cells to increase a static noise margin of the first one of the plurality of cells for a read operation.

15. The method of Claim 14, further comprising the steps of:
asserting the wordline signal to the first and second pass transistors for a write operation;
asserting the write wordline signal to the first and second write only pass transistors for the write operation, the write wordline signal lowering a beta ratio of the first one of the plurality of cells to enhance the write operation.

16. A method of operating a memory cell having a structure of claim 2, comprising the steps of:
asserting a wordline signal to the first and second pass transistors associated with a plurality of cells in the memory for a read operation;
deasserting a bitline select signal to the first and second bitline select transistors associated with a first one of the plurality of cells for the read operation such that the first one of the plurality of cells is activated without activating any other of the plurality of the cells;
deasserting a write wordline signal to the first and second write only pass transistors associated with the plurality of cells to increase a static noise margin of the first one of the plurality of cells for a read operation.

17. The method of Claim 16, further comprising the steps of:
asserting the bitline select signal to the first and second bitline select transistors for a write operation;
asserting the write wordline signal to the first and second write only pass transistors for the write operation, the write wordline signal lowering a beta ratio of the first one of the plurality of cells to enhance the write operation.

18. The method of any of claims 14 to 17, wherein said method comprises performing said steps for operating a low power static random access memory (SRAM).

## Patentansprüche

1. Speicherzelle, welche aufweist:
einen ersten und einen zweiten Inverter (12, 18), die über Kreuz geschaltet sind, wobei der erste Inverter einen ersten Ausgangsknoten (13) aufweist und der zweite Inverter einen zweiten Ausgangsknoten (17) aufweist,
einen ersten Durchlaßtransistor (24), der zwischen den Ausgangsknoten des ersten Inverters und einen ersten Durchlaßknoten (35) geschaltet ist,
einen ersten Schreib-Durchlaßtransistor (32), der zwischen den Ausgangsknoten des Inverters und den ersten Durchlaßknoten geschaltet ist,
einen zweiten Durchlaßtransistor (26), der zwischen den Ausgangsknoten des zweiten Inverters und einen zweiten Durchlaßknoten (37) geschaltet ist, und
einen zweiten Schreib-Durchlaßtransistor (34), der zwischen den Ausgangsknoten des zweiten Inverters und den zweiten Durchlaßknoten geschaltet ist,
**dadurch gekennzeichnet, daß** die Zelle weiter aufweist:
einen ersten Bitleitungs-Wähltransistor (28), der zwischen den ersten Durchlaßknoten und eine erste Bitleitung (36) geschaltet ist, und
einen zweiten Bitleitungs-Wähltransistor (30), der zwischen den zweiten Durchlaßknoten und eine zweite Bitleitung (38) geschaltet ist,
wobei der erste und der zweite Schreib-Durchlaßtransistor Nurschreib-Durchlaßtransistoren sind.

2. Speicherzelle, welche aufweist:
einen ersten und einen zweiten Inverter (12, 18), die über Kreuz geschaltet sind, wobei der erste Inverter einen ersten Ausgangsknoten (13) aufweist und der zweite Inverter einen zweiten Ausgangsknoten (17) aufweist,
einen ersten Durchlaßtransistor (24), der zwischen den Ausgangsknoten des ersten Inverters und eine erste Bitleitung (36) geschaltet ist,
einen ersten Schreib-Durchlaßtransistor (32), der zwischen den Ausgangsknoten des Inverters und einen ersten Durchlaßknoten geschaltet ist,
einen zweiten Durchlaßtransistor (26), der zwischen den Ausgangsknoten des zweiten Inverters und eine zweite Bitleitung (38) geschaltet ist, und
einen zweiten Schreib-Durchlaßtransistor (34), der zwischen den Ausgangsknoten des zweiten Inverters und einen zweiten Durchlaßknoten geschaltet ist,
**dadurch gekennzeichnet, daß** die Zelle weiter aufweist:
einen ersten Bitleitungs-Wähltransistor (28), der zwischen die erste Bitleitung und den ersten Durchlaßknoten geschaltet ist, und
einen zweiten Bitleitungs-Wähltransistor (30), der zwischen die zweite Bitleitung und einen zweiten Durchlaßknoten geschaltet ist,
wobei der erste und der zweite Schreib-Durchlaßtransistor Nurschreib-Durchlaßtransistoren sind.

3. Speicherzelle, welche aufweist:
einen ersten und einen zweiten Inverter (12, 18), die über Kreuz geschaltet sind, wobei der erste Inverter einen ersten Ausgangsknoten (13) aufweist und der zweite Inverter einen zweiten Ausgangsknoten (17) aufweist,
einen ersten Durchlaßtransistor (24), der zwischen einen ersten Durchlaßknoten (35) und eine erste Bitleitung (36) geschaltet ist,
einen ersten Schreib-Durchlaßtransistor (32), der zwischen die erste Bitleitung und den ersten Durchlaßknoten geschaltet ist,
einen zweiten Durchlaßtransistor (26), der zwischen einen zweiten Durchlaßknoten (37) und eine zweite Bitleitung (38) geschaltet ist, und
einen zweiten Schreib-Durchlaßtransistor (34), der zwischen die zweite Bitleitung und den zweiten Durchlaßknoten geschaltet ist,
**dadurch gekennzeichnet, daß** die Zelle weiter aufweist:
einen ersten Bitleitungs-Wähltransistor (28), der zwischen den Ausgangsknoten des ersten Inverters und den ersten Durchlaßknoten geschaltet ist, und
einen zweiten Bitleitungs-Wähltransistor (30), der zwischen den Ausgangsknoten des zweiten Inverters und den zweiten Durchlaßknoten geschaltet ist,
wobei der erste und der zweite Schreib-Durchlaßtransistor Nurschreib-Durchlaßtransistoren sind.

4. Speicherzelle nach Anspruch 1, 2 oder 3, wobei der erste Inverter einen ersten Pull-Up-Transistor (14) und einen ersten Pull-Down-Transistor (16) aufweist und der zweite Inverter einen zweiten Pull-Up-Transistor (20) und einen zweiten Pull-Down-Transistor (22) aufweist.

5. Speicherzelle nach einem der vorstehenden Ansprüche, wobei der erste Inverter einen ersten p-Kanal-Pull-Up-Transistor (14) und einen ersten n-Kanal-Pull-Down-Transistor (16) aufweist und der zweite Inverter einen zweiten p-Kanal-Pull-Up-Transistor (20) und einen zweiten n-Kanal-Pull-Down-Transistor (22) aufweist.

6. Speicherzelle nach einem der vorstehenden Ansprüche, wobei der erste und der zweite Durchlaßtransistor, der erste und der zweite Bitleitungs-Wähltransistor und der erste und der zweite Nurschreib-Durchlaßtransistor N-Kanäle sind.

7. Speicherzelle nach einem der vorstehenden Ansprüche, wobei der erste Nurschreib-Durchlaßtransistor und der erste Bitleitungs-Wähltransistor größere Breiten aufweisen als der erste Durchlaßtransistor und der zweite Nurschreib-Durchlaßtransistor und der zweite Bitleitungs-Wähltransistor größere Breiten als der zweite Durchlaßtransistor aufweisen.

8. Speicherzelle nach einem der vorstehenden Ansprüche, wobei die Breite des ersten Nurschreib-Durchlaßtransistors wenigstens das 0,5Fache der Breite des ersten Durchlaßtransistors beträgt und die Breite des zweiten Nurschreib-Durchlaßtransistors wenigstens das 0,5Fache der Breite des zweiten Durchlaßtransistors beträgt.

9. Speicherzelle nach einem der vorstehenden Ansprüche, wobei die Zelle für Niederspannungs- oder Niederleistungsanwendungen mit einer Versorgungsspannung von 1,5 Volt oder weniger verwendet wird.

10. Speicherzelle nach einem der vorstehenden Ansprüche, wobei der erste und der zweite Durchlaßtransistor p-Kanal-Konfigurationen aufweisen.

11. Speicherzelle nach einem der vorstehenden Ansprüche, wobei der erste und der zweite Nurschreib-Durchlaßtransistor p-Kanal-Konfigurationen aufweisen.

12. Speicherzelle nach einem der vorstehenden Ansprüche, wobei der erste und der zweite Bitleitungs-Wähltransistor p-Kanal-Konfigurationen aufweisen.

13. Speicherzelle nach einem der vorstehenden Ansprüche, wobei die Speicherzelle eine statische Direktzugriffs-Speicherzelle ist.

14. Verfahren zum Betreiben einer Speicherzelle mit einem Aufbau nach Anspruch 1 oder 3, welches die folgenden Schritte aufweist:
Anlegen eines Wortleitungssignals an die mehreren Zellen in dem Speicher zugeordneten ersten und zweiten Durchlaßtransistoren für einen Lesevorgang,
Anlegen eines Bitleitungs-Wählsignals an die einer ersten der mehreren Zellen zugeordneten ersten und zweiten Bitleitungs-Wähltransistoren für den Lesevorgang, so daß die erste der mehreren Zellen aktiviert wird, ohne daß eine andere der mehreren Zellen aktiviert wird, und
Nichtanlegen eines Schreib-Wortleitungssignals an die den mehreren Zellen zugeordneten ersten und zweiten Nurschreib-Durchlaßtransistoren, um den statischen Rauschabstand der ersten der mehreren Zellen für einen Lesevorgang zu vergrößern.

15. Verfahren nach Anspruch 14, welches die folgenden weiteren Schritte aufweist:
Anlegen des Wortleitungssignals an die ersten und zweiten Durchlaßtransistoren für einen Schreibvorgang und
Anlegen des Schreib-Wortleitungssignals an die ersten und die zweiten Nurschreib-Durchlaßtransistoren für den Schreibvorgang, wobei das Schreib-Wortleitungssignal das Betaverhältnis der ersten der mehreren Zellen verringert, um den Schreibvorgang zu verbessern.

16. Verfahren zum Betreiben einer Speicherzelle mit einem Aufbau nach Anspruch 2, welches die folgenden Schritte aufweist:
Anlegen eines Wortleitungssignals an die mehreren Zellen in dem Speicher zugeordneten ersten und zweiten Durchlaßtransistoren für einen Lesevorgang,
Nichtanlegen eines Bitleitungs-Wählsignals an die einer ersten der mehreren Zellen zugeordneten ersten und zweiten Bitleitungs-Wähltransistoren für den Lesevorgang, so daß die erste der mehreren Zellen aktiviert wird, ohne daß eine andere der mehreren Zellen aktiviert wird, und
Nichtanlegen eines Schreib-Wortleitungssignals an die den mehreren Zellen zugeordneten ersten und zweiten Nurschreib-Durchlaßtransistoren, um den statischen Rauschabstand der ersten der mehreren Zellen für einen Lesevorgang zu erhöhen.

17. Verfahren nach Anspruch 16, welches weiter die folgenden Schritte aufweist:
Anlegen des Bitleitungs-Wählsignals an den ersten und den zweiten Bitleitungs-Wähltransistor für einen Schreibvorgang und
Anlegen des Schreib-Wortleitungssignals an die ersten und die zweiten Nurschreib-Durchlaßtransistoren für den Schreibvorgang, wobei das Schreib-Wortleitungssignal das Betaverhältnis der ersten der mehreren Zellen verringert, um den Schreibvorgang zu verbessern.

18. Verfahren nach einem der Ansprüche 14 bis 17, welches das Ausführen der Schritte zum Betreiben eines statischen Direktzugriffsspeichers (SRAMs) mit niedriger Leistungsaufnahme aufweist.

## Revendications

1. Cellule de mémoire comprenant:
des premier et second inverseurs (12, 18) couplés selon un couplage croisé, le premier inverseur incluant un premier noeud de sortie (13) du premier inverseur et le second inverseur incluant un second noeud de sortie (17);
un premier transistor de transfert (24) connecté entre le noeud de sortie du premier inverseur et un premier noeud de transfert (35);
un premier transistor de transfert d'écriture (32) connecté entre le noeud de sortie de l'inverseur et le premier noeud de transfert;
un second transistor de transfert (26) connecté entre le noeud de sortie du second inverseur et le second noeud de transfert (37); et
un second transistor de transfert d'écriture (34) connecté entre le noeud de sortie du second inverseur et le second noeud de transfert;
**caractérisée en ce que** la cellule comprend en outre:
un transistor (28) de sélection d'une première ligne de bits, connecté entre le premier noeud de transfert et une première ligne de bits (36);
un transistor (30) de sélection d'une seconde ligne de bits, connecté entre le second noeud de transfert et une seconde ligne de bits (38);
les premier et second transistors de transfert d'écriture étant des transistors de transfert pour écriture seule.

2. Cellule de mémoire comprenant:
des premier et second inverseurs (12, 18) couplés selon un couplage croisé, le premier inverseur comprenant un premier noeud de sortie (13) du premier inverseur et le second inverseur incluant un second noeud de sortie (17);
un premier transistor de transfert (24) connecté entre le noeud de sortie du premier inverseur et une première ligne de bits (36);
un premier transistor de transfert d'écriture (32) connecté entre le noeud de sortie de l'inverseur et le premier noeud de transfert;
un second transistor de transfert (26) connecté entre le noeud de sortie du second inverseur et une seconde ligne de bits (38); et
un second transistor de transfert d'écriture (34) connecté entre le noeud de sortie du second inverseur et un second noeud de transfert;
**caractérisée en ce que** la cellule comprend en outre:
un transistor (28) de sélection de la première ligne de bits, connecté entre la première ligne de bits et le premier noeud de transfert;
un transistor (30) de sélection de la seconde ligne de bits, connecté entre la seconde ligne de bits et un second noeud de transfert;
les premier et second transistors de transfert d'écriture étant des transistors de transfert pour écriture seule.

3. Cellule de mémoire comprenant:
des premier et second inverseurs (12, 18) couplés selon un couplage croisé, le premier inverseur comprenant un premier noeud de sortie (13) du premier inverseur et le second inverseur incluant un second noeud de sortie (17);
un premier transistor de transfert (24) connecté entre un premier noeud de transfert (35) et une première ligne de bits (36);
un premier transistor de transfert d'écriture (32) connecté entre la première ligne de bits et le premier noeud de transfert;
un second transistor de transfert (26) connecté entre un second noeud de transfert (37) et une seconde ligne de bits (38); et
un second transistor de transfert pour écriture (34) connecté entre la seconde ligne de bits et le second noeud de transfert;
**caractérisée en ce que** la cellule comprend en outre:
un transistor (28) de sélection de la première ligne de bits, connecté entre le noeud de sortie du premier inverseur et le premier noeud de transfert;
un transistor (30) de sélection de la seconde ligne de bits, connecté entre le noeud de sortie du second inverseur et le second noeud de transfert;
les premier et second transistors de transfert d'écriture étant des transistors de transfert pour écriture seule.

4. Cellule de mémoire selon la revendication 1 ou la revendication 2 ou la revendication 3, dans laquelle ledit premier inverseur comprend un premier transistor élévateur (14) et un premier transistor abaisseur (16), et ledit inverseur inclut un second transistor élévateur (20) et un second transistor abaisseur (22).

5. Cellule de mémoire selon l'une des revendications précédentes, dans laquelle ledit premier inverseur inclut un premier transistor élévateur à canal p (14) et un premier transistor abaisseur à canal n (16), et ledit inverseur inclut un second transistor élévateur à canal p (20) et un second transistor abaisseur à canal n (22).

6. Cellule de mémoire selon l'une des revendications précédentes, dans laquelle lesdits premier et second transistors de transfert, lesdits transistors de sélection des première et seconde lignes de bits et lesdits premier et second transistors de transfert pour écriture seule sont des transistor à canal N.

7. Cellule de mémoire selon l'une des revendications précédentes, dans laquelle les premiers transistors de transfert pour écriture seule et le transistor de sélection de la première ligne de bits possèdent des largeurs supérieures à celles du premier transistor de transfert, et le second transistor de transfert pour écriture seule et le transistor de sélection de la seconde ligne de bits possèdent des largeurs supérieures à celles du second transistor de transfert.

8. Cellule de mémoire selon l'une des revendications précédentes, dans laquelle le premier transistor de transfert pour écriture seule possède une largeur égale à 0,5 fois ou plus la largeur du premier transistor de transfert, et le second transistor de transfert pour écriture seule possède une largeur égale à 0,5 fois ou plus la largeur du second transistor de transfert.

9. Cellule de mémoire selon l'une des revendications précédentes, dans laquelle la cellule est utilisée pour des applications à faible tension et à faible puissance possédant une tension d'alimentation de 1,5 volt ou moins.

10. Cellule de mémoire selon l'une des revendications précédentes, dans laquelle les premier et second transistors de transfert possèdent des configurations à canal p.

11. Cellule de mémoire selon l'une des revendications précédentes, dans laquelle les premier et second transistors de transfert pour écriture seule ont des configurations à canal p.

12. Cellule de mémoire selon l'une des revendications précédentes, dans laquelle les transistors de sélection des première et seconde lignes de bits possèdent des configurations à canal p.

13. Cellule de mémoire selon l'une quelconque des revendications précédentes, dans laquelle la cellule de mémoire est une cellule de mémoire statique à accès direct.

14. Procédé pour faire fonctionner une cellule de mémoire possédant une structure selon la revendication 1 ou la revendication 3, comprenant les étapes consistant à:
appliquer un signal de ligne de mots envoyé au premier et second transistors de transfert associés à une pluralité de cellules dans la mémoire pour une opération de lecture;
appliquer un signal de sélection de lignes de bits aux transistors de sélection des première et seconde lignes de bits associées à une première de la pluralité de cellules pour l'opération de lecture de telle sorte que la première de la pluralité de cellules est activée sans activation d'une quelconque autre de la pluralité de cellules;
supprimer l'application d'un signal de ligne de mots d'écriture aux premier et second transistors de transfert pour écriture seule associés à la pluralité de cellules pour augmenter une marge de bruit statique de la première de la pluralité de cellules pour une opération de lecture.

15. Procédé selon la revendication 14, comprenant en outre les étapes consistant à:
appliquer le signal de ligne de mots envoyé aux premier et second transistors de transfert pour une opération d'écriture;
appliquer le signal de ligne de mots d'écriture aux premier et second transistors de transfert pour écriture seule pour l'opération d'écriture, le signal de ligne de mots d'écriture réduisant un rapport bêta de la première de la pluralité de cellules pour améliorer l'opération d'écriture.

16. Procédé pour faire fonctionner une cellule de mémoire possédant une structure selon la revendication 2, comprenant les étapes consistant à:
appliquer un signal de ligne de mots envoyé aux premier et second transistors de transfert associés à une pluralité de cellules dans la mémoire pour une opération de lecture;
supprimer l'application d'un signal de sélection de lignes de bits aux transistors de sélection des première et seconde lignes de bits associés à une première de la pluralité de cellules pour l'opération de lecture de telle sorte que la première de la pluralité de cellules est activée sans activation d'une quelconque autre cellule de la pluralité de cellules;
supprimer l'application d'un signal de ligne de mots d'écriture aux premier et second transistors de transfert à écriture seule, associés à la pluralité de cellules pour augmenter une marge de bruit statique d'une première cellule de la pluralité de cellules pour une opération de lecture.

17. Procédé selon la revendication 16, comprenant en outre les étapes consistant à:
appliquer le signal de sélection de lignes de bits aux transistors de sélection des première et seconde lignes de bits pour une opération d'écriture;
appliquer le signal de ligne de mots d'écriture aux premier et second transistors de transfert pour écriture seule pour l'opération d'écriture, le signal de ligne de mots d'écriture réduisant un rapport bêta de la première cellule de la pluralité de cellules pour améliorer l'opération d'écriture.

18. Procédé selon l'une quelconque des revendications 14 à 17, selon lequel ledit procédé comprend l'exécution desdites étapes pour faire fonctionner une mémoire statique à accès direct de faible puissance (SRAM).
